Europäisches Patentamt

European Patent Office

Office européen des brevets

(11) Publication number: **0 047 886**
**B1**

(12) **EUROPEAN PATENT SPECIFICATION**

(45) Date of publication of patent specification: **28.05.86**

(51) Int. Cl.⁴: **H 01 L 23/52**

(21) Application number: **81106599.4**

(22) Date of filing: **25.08.81**

(54) Semiconductor device.

(30) Priority: **12.09.80 JP 126738/80**

(43) Date of publication of application:
**24.03.82 Bulletin 82/12**

(45) Publication of the grant of the patent:
**28.05.86 Bulletin 86/22**

(84) Designated Contracting States:
**DE FR GB**

(56) References cited:
**IBM TECHNICAL DISCLOSURE BULLETIN Vol.
23, No. 6, November 1980 New York W.W. WU
"Personalizable Semiconductor Device with
Diffusion for Preventing Short Circuit from
Laser Weld"**

**Patent Abstracts of Japan Vol.4, No.104, 25th
July, 1980**

(73) Proprietor: **Kabushiki Kaisha Toshiba
72, Horikawa-cho Saiwai-ku
Kawasaki-shi Kanagawa-ken 210 (JP)**

(72) Inventor: **Shiotari, Yoshihisa
4678-11, Kamiiida-cho
Totsuka-ku Yokohama-shi (JP)**

(74) Representative: **Henkel, Feiler, Hänzel & Partner
Möhlstrasse 37
D-8000 München 80 (DE)**

## Description

This invention relates to a semiconductor device having a semiconductor substrate of one conductivity type.

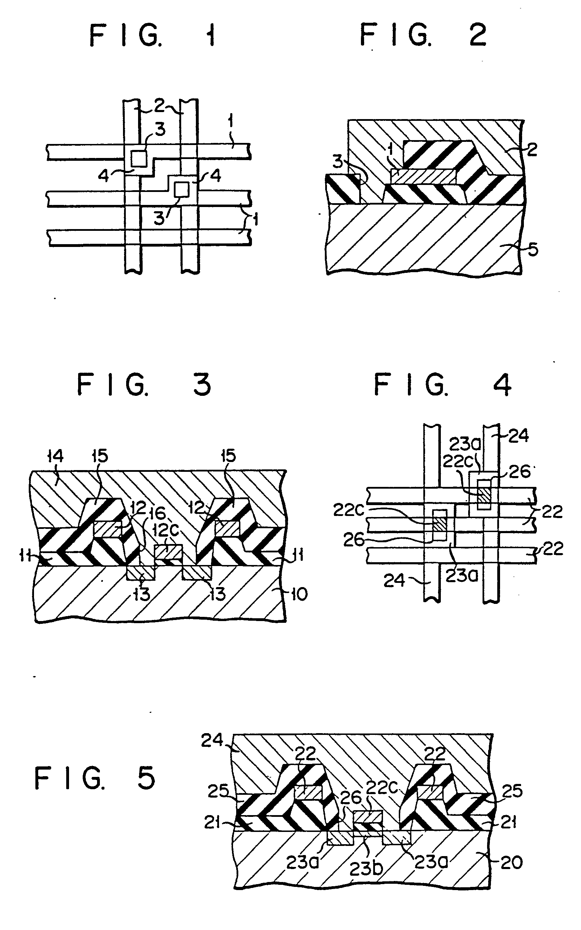

Two wiring layers included in a lattice arrangement which stepwise intersect each other, for example, at right angles generally have such a junction as shown in Fig. 1. Where a first wiring layer 1 of polycrystalline silicon acting as a gate electrode is connected to a second rectangularly intersecting wiring layer of aluminium at the junction, it is necessary to enlarge the contact section 4 of the first wiring layer 1 or let said contact section 4 project from the first wiring layer 1 in order to compensate for those changes in the position of a contact hole 3 produced by etching which might result from the displacement of a mask. Unless the contact section 4 is provided, the displacement of the mask would give rise to the possibility of the second wiring layer being short-circuited with a semiconductor substrate 5, in case, as shown in Fig. 2, the contact hole 3 is displaced from the end of the first wiring layer 1. For the formation of such large contact section 4, therefore the pitch of every adjacent first wiring layer 1 can not be reduced, presenting great difficulties in elevating the density with which the aforesaid lattice-arranged wiring layers are integrated.

The above semiconductor device is not comprised in the state of the art according to Art. 54(2)EPC, since the Applicants are not aware of any published document disclosing such a device.

The document "IBM Technical Disclosure Bulletin", vol. 23, No. 6, November 1980, page 2336 discloses a semiconductor device in which an upper metal layer and a lower metal layer separated from each other by an insulating layer are welded together by a laser beam. A special diffusion region of the opposite conductivity type to that of the semiconductor substrate protects this semiconductor device in case the laser beam penetrates below the lower metal layer. A contact hole is not provided, with result that the position and size of the diffusion region are not regulated. In other words, a short circuit is likely to take place between the metal layers and the substrate depending on the degree of deviation in the relative positions of the metal layers and the diffusion region caused in the masking step during the manufacture of the semiconductor device.

It is accordingly an object of this invention to provide a highly reliable semiconductor device in which short-circuiting between the wiring layers and the semiconductor substrate can be completely suppressed and in which furthermore the pitch of every adjacent wiring layers can be reduced so that the wiring layers can be integrated with a greater density.

The present invention provides a semiconductor device having a semiconductor substrate of one conductivity type, a first group of wiring layers formed on a first insulation layer provided on the substrate, a second group of wiring layers crossing over the first group, a wiring layer of the second group being connected to a selected connection area of a wiring layer of the first group through a contact hole in a second insulation layer provided on the first insulation layer, the contact hole being aligned with an opening in the first insulation layer exposing the substrate, the device further comprising barrier regions having a conductivity type opposite to that of the substrate and formed on those portions of the surface of the substrate which lie below and around or around the selected connection area of the first wiring layer.

Thus, this invention provides a semiconductor device in which those portions of the surface of a semiconductor substrate which are disposed below and around the that section of the first wiring layer to which the second wiring layer is to be connected is provided with a barrier region having the opposite conductivity type to that of the semiconductor substrate.

The barrier region prevents short circuiting between the semiconductor substrate and part of the second wiring connected to the first wiring layer, thereby eliminating the necessity of forming a large contact section as is the case with the prior art, and minimizing the wiring layer pitch.

This invention can be more fully understood from the following detailed description when taken in conjunction with the accompanying drawings, in which:

Fig. 1 is a plan view showing the manner in which the lattice-arranged wiring layers of the prior art semiconductor device are connected to each other;

Fig. 2 is a sectional view showing short-circuiting between the semiconductor substrate and the second wiring layer occurring in the conventional semiconductor device;

Fig. 3 is a sectional view of a semiconductor device embodying this invention in which the construction of the junction of every adjacent wiring layers is improved;

Fig. 4 is a plan view showing the junction of every adjacent wiring layers of the semiconductor device of the invention; and

Fig. 5 is a sectional view of the semiconductor device of the invention.

Description is now given with reference to Fig. 3 of a semiconductor device in which the construction of every adjacent wiring layers is improved to prevent the short-circuiting between the semiconductor substrate and the second wiring layer. A barrier region 13 is formed on that portion of the surface of the semiconductor substrate 10 which surrounds the selected connection area 12c of a first wiring layer 12 with the opposite conductivity type to that of the semiconductor substrate 10 by ion implantation with a first insulation layer 11 and the first wiring layer 12 formed thereon used as a mask. The second wiring layer 14 is connected to the selected connection area 12c of the first wiring layer 12 through a contact hole 16 of a second insulation layer 15. The second wiring layer 14 separated from the semiconductor substrate 10 by a PN junction is prevented from short-circuiting with the semiconductor substrate 10.

However, the second wiring layer 14 prepared from, for example, aluminium often intrudes during formation into the semiconductor substrate from a boundary between the portion of the first insulation layer 11 which lies under the selected connection area 12c of the first wiring layer 12 and the barrier region 13. As a result, short-circuiting arises between the semiconductor substrate 10 and the second wiring layer 14, thereby reducing the reliability and yield of a semiconductor device produced.

With the semiconductor device of this invention shown in Figs. 4 and 5, it is possible to prevent short-circuiting between the semiconductor substrate 10 and the second wiring layer due to its intrusion into said semiconductor substrate 10. As shown in Fig. 5, barrier regions 23a, 23b are formed on those portions of the surface of the semiconductor substrate 20 which lie around and below the selected connection area 22c of the first wiring layer 22 deposited on the first insulation layer 21 with the opposite conductivity type to that of the semiconductor substrate 20. A contact hole 26 is formed in a second insulation layer 25 deposited on the first wiring layer 22. A second wiring layer 24 is connected to the selected connection area 22c, which has been exposed. The contact hole 26 may be larger than the selected connection area 22c, but should be smaller than the barrier regions 23a, 23b. As indicated in Figs. 4 and 5, the selected contact area 22c of the first wiring layer 22 may be as wide as the first wiring layer 22, thereby minimizing the interwiring layer distance.

The semiconductor device of this invention can be manufactured by the same process as that by which a transistor is produced, without applying any additional step. Namely, the barrier regions can be formed by the steps of selectively depositing a resist on a silicon oxide layer already mounted, for example, on a P type semiconductor substrate, forming an N type impurity by ion implantation in the P type semiconductor substrate through a thin resist-free portion of said silicon oxide layer. A polycrystalline silicon layer is laminated. This polycrystalline silicon layer is selectively etched to provide a first wiring layer. A thin silicon oxide layer set on the barrier regions is etched with the selected connection area of the first wiring layer as a mask. An N type impurity is again introduced by the ordinary diffusion or ion implantation process to form a deep barrier region around the selected connection area of the first wiring layer. Later, a silicon oxide layer acting as a second insulation layer is superposed on the whole mass. Thereafter a contact hole is formed to expose the selected connection area of the first wiring layer and part of the barrier regions. Last, a second wiring layer is prepared from aluminium. This second aluminium wiring layer is connected to the selected connection area of a polycrystalline silicon wiring layer through the contact hole and also to part of the barrier regions exposed around the selected connection area of the first wiring layer.

The foregoing description refers to the case where the barrier regions surrounding the selected connection area were formed with a greater depth than the barrier regions lying below said selected connection area. Obviously, all the barrier regions may be formed with the same depth. The barrier regions surrounding the selected connection area of the first wiring layer and those which lie below said selected connection area are made contiguous to each other. The first wiring layers may be prepared from molybdenum or any other metal in place of polycrystalline silicon. The barrier regions are only required to have the opposite conductivity to that of the semiconductor substrate. Namely, the barrier regions may be P or N type, depending on the conductivity type of the semiconductor substrate.

**Claims**

1. A semiconductor device having a semiconductor substrate (10, 20) of one conductivity type, a first group of wiring layers (12, 22) formed on a first insulation layer (11, 21) provided on the substrate, second group of wiring layers (14, 24) crossing over the first group, a wiring layer of the second group being connected to a selected connection area (12c, 22c) of a wiring layer of the first group through a contact hole (16, 26) in a second insulation layer provided on the first insulation layer, the contact hole being aligned with an opening in the first insulation layer exposing the substrate, the device further comprising barrier regions (13, 23a, 23b) having a conductivity type opposite to that of the substrate and formed on those portions of the surface of the substrate which lie below and around or around the selected connection area (12c, 22c) of the first wiring layer.

2. The semiconductor device according to claim 1, wherein the peripheral edges of the barrier regions (13, 23a, 23b) are positioned below the second insulation layer (15, 25) on the outside of the contact hole (16, 26).

3. The semiconductor device according to claim 1 or 2, wherein the barrier region (23a) surrounding the expected connection area of the first wiring layer (12, 22) is formed with a greater depth than that (23b) which lies below said selected connection area.

4. The semiconductor device according to claim 1 or 2, wherein the barrier region surrounding the selected connection area of the first wiring layer (12, 22) and that which is positioned below said selected connection area are formed with the same depth.

**Patentansprüche**

1. Halbleitervorrichtung mit einem Halbleitersubstrat (10, 20) eines Leitfähigkeitstyps, einer ersten Gruppe von auf einer auf dem Substrat vorgesehenen ersten Isolierschicht (11, 21) ausgebildeten Leiterzügen (12, 22), einer die erste Gruppe kreuzenden zweiten Gruppe von Leiterzügen (14, 24), wobei ein Leiterzug der zweiten Gruppe über ein Kontaktloch (16, 26) in einer auf der ersten Isolierschicht vorgesehenen zweiten Isolierschicht an einen ausgewählten Anschlußbereich (12c, 22c) eines Leiterzugs der ersten Gruppe angeschlossen ist, das Kontaktloch mit einer das Substrat freilegenden Öffnung in der ersten Isolierschicht ausgerichtet ist und die Vorrichtung zusätzlich Sperrbereiche (13, 23a, 23b) eines dem Leitfähigkeitstyp des Substrats entgegengesetzten Leitfähigkeitstyps, die auf denjenigen Teilen der Substratoberfäche, die unter dem und rundum den oder rundum den ausgewählten Anschlußbereich (12c, 22c) des ersten Leiterzugs liegen, aufweist.

2. Halbleitervorrichtung nach Anspruch 1, dadurch gekennzeichnet, daß die Umfangskanten der Sperrbereiche (13, 23a, 23b) unter der zweiten Isolierschicht (15, 25) auf der Außenseite des Kontaktlochs (16, 26) angeordnet sind.

3. Halbleitervorrichtung nach Ansprüchen 1 oder 2, dadurch gekennzeichnet, daß der den vorgesehenen Anschlußbereich des ersten Leiterzugs (12, 22) umgebende Sperrbereich (23a) tiefer gelegt ist als der unter dem ausgewählten Anschlußbereich liegende Sperrbereich (23b).

4. Halbleitervorrichtung nach Ansprüchen 1 oder 2, dadurch gekennzeichnet, daß der den ausgewählten Anschlußbereich des Leiterzugs (12, 22) umgebende Sperrbereich und der unter dem ausgewählten Anschlußbereich liegende Sperrbereich in gleicher Tiefe gebildet sind.

**Revendications**

1. Dispositif semiconducteur possédant un substrat semiconducteur (10, 20) d'un premier type de conductivité, un premier groupe de couches de câblage (12, 22) formé sur une première couche d'isolation (11, 21) disposée sur le substrat, un deuxième groupe de couches de câblage (14, 24) croisant le premier groupe au-dessus de celui-ci, une couche de câblage du deuxième groupe étant connectée à une aire de connexion sélectionnée (12c, 22c) d'une couche de câblage du premier groupe par l'intermédiaire d'un trou de contact (16, 26) ménagé dans une deuxième couche d'isolation disposée sur la première couche d'isolation, le trou de contact étant aligné avec une ouverture ménagée dans la première couche d'isolation laissant voir le substrat, le dispositif comprenant en outre des régions de barrières (13, 23a, 23b) possédant un type de conductivité opposé à celui du substrat et formées sur les parties de la surface du substrat qui se trouvent au-dessous et autour ou bien autour de l'aire de connexion sélectionnée (12c, 22c) de la première couche de câblage.

2. Dispositif semiconducteur selon la revendication 1, où les bords périphériques des régions de barrières (13, 23a, 23b) sont placés au-dessous de la deuxième couche d'isolation (15, 25) sur l'extérieur du trou de contact (16, 26).

3. Dispositif semiconducteur selon la revendication 1 ou 2, où la région de barrière (23a) entourant l'aire de connexion sélectionnée de la première couche de câblage (12, 22) est dotée d'une plus grande profondeur que celle (23b) qui se trouve au-dessous de ladite aire de connexion sélectionnée.

4. Dispositif semiconducteur selon la revendication 1 ou 2, où la région de barrière entourant l'aire de connexion sélectionnée de la première couche de câblage (12, 22) et celle qui est placée au-dessous de ladite aire de connexion sélectionnée reçoivent la même profondeur.

FIG. 1

FIG. 2

FIG. 3

FIG. 4

FIG. 5